# EUROPÄISCHE PATENTSCHRIFT

(11) **EP 0 818 061 B1**
(45) Veröffentlichungstag und Bekanntmachung des Hinweises auf die Patenterteilung: **27.12.2000**
(21) Anmeldenummer: 96911960.1
(22) Anmeldetag: 28.03.1996
(51) Int. Cl.: H01R 4/04, H01B 1/22, H05K 3/10, H05K 3/12

(54) **VERFAHREN ZUR ERZEUGUNG ELEKTRISCH LEITFÄHIGER VERBINDUNGSSTRUKTUREN**
PROCESS FOR PRODUCING ELECTRICALLY CONDUCTIVE CONNECTING STRUCTURES
PROCEDE DE PRODUCTION DES STRUCTURES DE CONNEXIONS ELECTROCONDUCTRICES

(30) Priorität: 29.03.1995 DE 19511553
(43) Veröffentlichungstag der Anmeldung: 14.01.1998
(73) Patentinhaber: LITTON PRECISION PRODUCTS INTERNATIONAL, INC., 82216 Gernlinden (DE)
(72) Erfinder: LÄNTZSCH, Michael, K., D-82194 Gröbenzell (DE); NETZMANN, Helmfried, D-86931 Prittriching (DE)
(74) Vertreter: Müller, Frithjof E., Dipl.-Ing.
(86) Internationale Anmeldenummer: EP9601373
(87) Internationale Veröffentlichungsnummer: WO9630966

(56) Entgegenhaltungen:
- EP-A- 0 414 363
- US-A- 2 959 498
- US-A- 3 569 607
- US-A- 3 800 020
- US-A- 5 376 403
- PATENT ABSTRACTS OF JAPAN vol. 005, no. 035 (C-046), 5.März 1981 & JP,A,55 160072 (MATSUSHITA ELECTRIC IND CO LTD), 12.Dezember 1980,
- ELECTRONIC DESIGN, Bd. 41, Nr. 6, 18.März 1993, Seite 32 XP000368031 MALINIAK D: "CONDUCTIVE-INK TECHNOLOGY REPLACES COPPER ON PC BOARDS"

## Beschreibung

Die vorliegende Erfindung betrifft ein Verfahren zur Erzeugung elektrisch leitfähiger Strukturen, eine nach diesem Verfahren erhaltene elektrisch leitfähige Struktur sowie eine Kombination zur Erzeugung elektrisch leitfähiger Strukturen.

Bei der Fertigung elektronischer Baugruppen bzw. bestückten Schaltungen ist es regelmäßig erforderlich, metallische Oberflächen mit metallischen Anschlußelementen mechanisch-elektrisch zu verbinden. Hierzu werden üblicherweise Leiterplatten auf galvanischem Wege hergestellt, wobei der Leiterbahnaufbau durch additive Techniken oder subtraktive Ätztechnologien erfolgt. Diese bekannten Verfahren implizieren jedoch Umweltverschmutzungsrisiken und die Notwendigkeit des Recyclings der hierbei verwendeten, galvanischen Flüssigkeiten. So hergestellte Leiterplatten dienen als Schichtträger für elektronische Bauelemente, die mit der Leiterplatte verbunden werden. In geringem Umfang werden hierzu auch elektrisch leitfähige Klebstoffe eingesetzt, die im Gegensatz zum Weichlöten den Vorteil niedriger Arbeitstemperaturen bieten. Bei diesen herkömmlichen leitfähigen Klebstoffen handelt es sich entweder um physikalische Mischungen aus elektrisch leitfähigen Materialien, wie Metallpulvern, und polymeren Harzen als Matrix, oder sie bestehen aus elektrisch leitfähigen Kunststoffen. Die Leitfähigkeit solcher Systeme kommt durch den quasi-metallischen Kontakt der leitfähigen Materialien in der organischen Matrix zustande.

Um eine gute Haftung auf Substraten zu erreichen, ist bei solchen elektrisch leitfähigen Klebstoffen ein hoher Anteil an polymeren Harzen erwünscht. Andererseits ist für eine gute elektrische Leitfähigkeit ein hoher Anteil an leitfähigen Materialien erforderlich. Die Haftung auf Substraten und die elektrische Leitfähigkeit sind damit gegenläufige Anforderungen an derartige Klebstoffe. Die hiermit erzielten Verbindungsstrukturen haben beispielsweise den Nachteil, daß sie nicht lötfähig sind. Diese und weitere technische Nachteile haben bisher den Einsatz leitfähiger Klebstoffe in großem Maße verhindert.

Ebenfalls sind elektrisch leitfähige Klebstoffe bekannt geworden, bei denen die Leitfähigkeit durch eine metallurgische Reaktion verschiedener Metalle unter Bildung intermetallischer Verbindungen vorgesehen wird. Auch hierbei ist es notwendig, eine organische Polymermatrix beizumischen, so daß die gleichen Probleme wie bei mit elektrisch leitfähigen Materialien gefüllten Klebstoffen auftreten.

Die EP 0 414 363 A2 beschreibt ein Verfahren zur Herstellung von leitfähigen Schaltverbindungen, bei dem durch eine Drucktechnik ein lösungsmittelhaltiges Klebstoffmaterial in einem ausgewählten Muster auf ein Substrat aufgetragen wird. Anschließend wird ein Metallpulver zugegeben, das an den mit Klebstoff versehenen Stellen haften bleibt. Nach Entfernen nichthaftenden Pulvers werden durch Erhitzen und Schmelzen der Metalle leitfähige Leiterbahnen entsprechend dem Muster des Auftrags des Klebstoffmaterials erzeugt. Als mögliche Bestandteile des Metallpulvers werden Zinn, Blei, Wismuth, Indium, Antimon und Silber genannt. Zur Entfernung des überschüssigen Pulvers von der Leiterplatte wird eine Vibrationsmaschine oder ein Gebläse vorgeschlagen.

Die US 3 800 020 beschreibt ein Verfahren zur Erzeugung eines Leiterbahnenmusters, bei dem ein Metallpulver auf ein thermoplastisches Material aufgetragen wird. Das thermoplastische Material und das Metallpulver werden anschließend gemeinsam durch Aufpressen und Erhitzen eines Stempels, der das gewünschte Muster der Leiterbahnen abbildet, im entsprechenden Muster geschmolzen, wodurch Leiterbahnen im gewünschten Layout erzeugt werden. Wiederum muß das verbliebene nichtgeschmolzene Pulver zum Beispiel durch Vibrations oder Saugverfahren abgetragen werden.

Der Erfindung liegt die Aufgabe zugrunde, ein Verfahren zur Erzeugung elektrisch leitfähiger Strukturen anzugeben, bei dem die Nachteile des Standes der Technik nicht auftreten, und insbesondere eine ausgezeichnete Haftung auf Trägern, eine gute elektrische Leitfähigkeit sowie Lötfähigkeit der erhaltenen Strukturen und Schaltungen erreicht wird.

Gegenstand der Erfindung ist daher ein Verfahren zur Erzeugung elektrisch leitfähiger Strukturen, umfassend die Schritte: (1) Aufbringen eines Klebstoffmaterials auf einen Träger; (2) Aufbringen einer mindestens zwei Metallpulver mit unterschiedlichen Schmelzpunkten in einer Gesamtmenge von mindestens 85 Gew. -% und eine geringe Menge organischer Hilfsstoffe, gewählt aus flüchtigen organischen Verbindungen, desoxidierenden Hilfsstoffen, die Metallpulver aktivierenden Substanzen und die Viskosität regelnden Additiven enthaltenden elektrisch leitfähigen Metallpaste, wobei die Metallpaste mindestens ein Metallpulver eines Metalls guter elektrischer Leitfähigkeit aus der Gruppe Gold, Silber, Kupfer und deren Legierungen und mindestens ein Metallpulver eines Metalls mit niedrigerem Schmelzpunkt als demjenigen des Metalls guter elektrischer Leitfähigkeit aus der Gruppe Zinn, Indium und deren Legierungen enthält, und wobei die Metallpulver in solchen Mengenanteilen gewählt sind, daß sie beim Erwärmen eine intermetallische Phase mit gegenüber den Ausgangsmetallen erhöhter Aufschmelztemperatur bilden, und wobei die organischen Hilfsstoffe bei der zur Bildung der intermetallischen Phase angewandten Temperatur größtenteils verflüchtigbar sind, auf das so vorgesehene Klebstoffmaterial; und (3) Erhitzen der so erhaltenen Anordnung bei einer Temperatur, bei der die Metallpulver eine intermetallische Phase mit einer gegenüber den Ausgangsmaterialien erhöhten Aufschmelztemperatur bilden.

Bei einer bevorzugten Ausführungsform des erfindungsgemäßen Verfahrens wird das Klebstoffmaterial in Form eines Schaltungsmusters aufgebracht, um eine Schaltung zu erzeugen. Wird bei dieser Ausführungsform das mit dem Klebstoffmaterial und der Metallpaste versehene Schaltungsmuster vor dem Erhitzen mit elektrischen oder elektronischen Bauelementen bestückt, so gelingt es, in einfacher Weise eine bestückte Schaltung herzustellen.

Mit Hilfe der Erfindung können, wie weiter unten genauer beschrieben, also elektrisch leitfähige Strukturen bzw. Schaltungen oder bestückte Schaltungen erhalten werden.

Zur Ausführung der Erfindung wird Gebrauch gemacht von einer Kombination zur Erzeugung elektrisch leitfähiger Strukturen, umfassend A) ein Klebstoffmaterial; und B) eine mindestens zwei Metallpulver mit unterschiedlichen Schmelzpunkten in einer Gesamtmenge von mindestens 85 Gew.-% und eine geringe Menge organischer Hilfsstoffe, gewählt aus flüchtigen organischen Verbindungen, desoxidierenden Hilfsstoffen, die Metallpulver aktivierenden Substanzen und die Viskosität regelnden Additiven enthaltende elektrisch leitfähige Metallpaste, wobei die Metallpaste mindestens ein Metallpulver eines Metalls guter elektrischer Leitfähigkeit aus der Gruppe Gold, Silber, Kupfer und deren Legierungen und mindestens ein Metallpulver eines Metalls mit niedrigerem Schmelzpunkt als demjenigen des Metalls guter elektrischer Leitfähigkeit aus der Gruppe Zinn, Indium und deren Legierungen enthält, und wobei die Metallpulver in solchen Mengenanteilen gewählt sind, daß sie beim Erwärmen eine intermetallische Phase mit gegenüber den Ausgangsmetallen erhöhter Aufschmelztemperatur bilden, und wobei die organischen Hilfsstoffe bei der zur Bildung der intermetallischen Phase angewandten Temperatur größtenteils verflüchtigbar sind.

Entgegen den bisher eingesetzten Techniken wurde erfindungsgemäß festgestellt, daß nur eine geringe Menge organischer Hilfsstoffe enthaltende, elektrisch leitfähige Metallpasten, bei denen die Metallpulver so gewählt sind, daß sie beim Erwärmen eine intermetallische Phase bilden, zur Erzeugung elektrisch leitfähiger Verbindungsstrukturen eingesetzt werden können. Die an sich unzureichende Haftung solcher Metallpasten auf Substraten bzw. Trägern wird durch ein Klebstoffmaterial erzielt, welches vorausgehend auf das Substrat bzw. den Träger aufgetragen wird.

Bei dem Klebstoffmaterial kann es sich um ein anorganisches oder ein organisches Material handeln. Anorganische und organische Klebstoffe sind dem Fachmann bekannt und können von diesem je nach Anwendungszweck, beispielsweise in Abhängigkeit der zu verwendenden Trägermaterialien ausgewählt werden. Anorganische Klebstoffe sind beispielsweise solche auf überwiegend mineralischer Basis, wie etwa auf Silikatbasis. Hydraulisch härtbare, anorganische Materialien können ebenso geeignet sein. Als Klebstoffe auf organischer Basis eignen sich beispielsweise thermoplastische Harze, insbesondere solche mit höheren Erweichungs- bzw. Schmelzpunkten. Als besonders geeignet haben sich härtbare organische Harze erwiesen, wobei die Härtung entweder thermisch oder durch Strahlung erfolgen kann.

Das Klebstoffmaterial enthält normalerweise keine metallischen Bestandteile und besitzt keine elektrische Leitfähigkeit. Seine Aufgabe ist es, eine fest haftende thermostabile Verbindung mit dem Träger einzugehen und die Haftung der zweiten Komponente, nämlich der elektrisch leitfähigen Metallpaste zu ermöglichen. Als Klebstoffmaterial können insbesondere Ein- und Zweikomponenten-Klebstoffe auf Epoxidarzbasis, Polyurethanharze, Melamin-Formaldehyd-Harze, Vinylidenchlorid-Vinylacetat-Copolymerharze oder als Lötstopplacke bekannte Materialien eingesetzt werden. Besonders bevorzugt sind Zweikomponenten-Klebstoffe auf Epoxidharzbasis. Die Wahl der jeweiligen Klebstoffe richtet sich nach den Adhäsionseigenschaften der verwendeten Träger, wie etwa Schaltungsträger und der dabei gegebenenfalls notwendigen Flexibilität.

Die erfindungsgemäß eingesetzte Metallpaste enthält geeigneterweise mindestens ein Metallpulver eines Metalls guter elektrischer Leitfähigkeit aus der Gruppe Gold, Silber, Kupfer und Legierungen davon, und mindestens ein Metallpulver eines Metalls mit niedrigerem Schmelzpunkt als demjenigen des Metalls guter elektrischer Leitfähigkeit aus der Gruppe Zinn, Indium und deren Legierungen, vorzugsweise deren Legierungen mit beispielsweise Blei und/oder Antimon und/oder Zink, wie etwa Zinnblei, Zinnantimon oder Zinnantimonblei. Gemäß der Erfindung ist es erforderlich, daß die Metallpulver mit unterschiedlichen Schmelzpunkten beim Erhitzen unter Bildung einer intermetallischen Phase eine metallurgische Reaktion eingehen. Additive Metallpulver aus der Gruppe Nickel, Germanium, Titan, Eisen, aber auch andere Legierungsbestandteile, die als sogennnte Kornrefiner bekannt geworden sind, können hierbei für die Erzielung spezieller Eigenschaften eingesetzt werden. Besonders bevorzugt ist eine Metallpaste, die eine Mischung aus Kupferpulver und einem Pulver der Lotlegierung 62Sn36Pb2Ag in einem Gewichtsverhältnis von etwa 4:1 bis etwa 1:1 enthält.

Die Metallpulver der Metallpaste weisen geeigneterweise eine mittlere Teilchengröße von etwa 1-100 µm, vorzugsweise etwa 10-50 µm, weiter vorzugsweise etwa 20-30 µm auf.

Der Gehalt an Metallpulver in der Metallpaste sollte so hoch wie möglich sein und beträgt erfindungsgemäß mindestens etwa 85 Gew.-%, vorzugsweise mindestens etwa 90 Gew.-%. Bei einem Metallpulvergehalt von über etwa 95 Gew.-% kann jedoch die Handhabung der Metallpaste Schwierigkeiten bereiten.

Als organische Hilfsstoffe kann die erfindungsgemäß eingesetzte Metallpaste beispielsweise flüchtige organische Verbindungen, wie etwa Lösungsmittel, beispielsweise Diole, Glykole, Glykolether und Dicarbonsäureester, desoxidierende Hilfsstoffe, die Metallpulver aktivierende Substanzen, wie Carbonsäuren und Amine, und die Viskosität regelnde Additive, wie langkettige Säureamide oder Paraffine enthalten. Bevorzugt werden Aminverbindungen, die bei den gewählten metallurgischen Reaktionstemperaturen flüchtig sind. Ferner können Coaktivatoren aus der Gruppe der nichtflüchtigen Carbonsäuren und Amine sowie bei der zur Bildung der intermetallischen Phase angewandten Temperatur halogenabspaltende Verbindungen enthalten sein. Die Auswahl dieser organischen Hilfsstoffe richtet sich beispielsweise nach der zu wählenden Auftragsmethode der Metallpaste. Ferner können geringe Anteile an Verdickungsmitteln, Bindemitteln, natürlichen Harzen, wie Kolophonium und Kolophoniumderivaten, in die Metallpasten eingebracht werden. Eine erfindungsgemäß geeignete Metallpaste besteht beispielsweise aus ca. 90 Gew.-% Metallpulver und etwa 10 Gew.-% organischen Hilfsstoffen.

Das erfindungsgemäße Verfahren zur Erzeugung elektrisch leitfähiger Strukturen umfaßt die Schritte des Aufbringens des Klebstoffmaterials auf einen Träger, des Aufbringens der Metallpaste auf das so vorgesehene Klebstoffmaterial und des Erhitzens der Metallpaste bzw. der so erhaltenen Anordnung bei einer Temperatur, bei der die Metallpulver eine intermetallische Phase bilden.

Vorzugsweise wird das auf den Träger aufgebrachte Klebstoffmaterial vor dem Aufbringen der Metallpaste einer Wärmebehandlung ausgesetzt, welche jedoch so bemessen ist, daß hierbei keine oder keine vollständige Härtung des Klebstoffmaterials erfolgt. Hierzu ist es zweckmäßig, das Klebstoffmaterial zunächst bei Umgebungstemperatur während einer angemessenen Zeitdauer abzulüften, um gegebenenfalls vorhandene Lösungsmittel zu verdampfen. Danach erfolgt eine Wärmebehandlung, beispielsweise bei 80°C während etwa 20 Minuten unter Laborbedingungen. Hierbei wird eine trockene, gut verarbeitbare Oberfläche des Klebstoffmaterials erhalten.

In einem nächsten Schritt wird dann auf die getrocknete Oberfläche des Klebstoffmaterials die vorangehend beschriebene Metallpaste aufgetragen. Die Aufbringung des Klebstoffmaterials und der Metallpaste kann geeigneterweise mittels eines Dispensers, eines Sieb- oder anderen Druckverfahrens nach dem Fachmann bekannten Techniken erfolgen.

Zur letztendlichen Bildung einer leitfähigen Verbindungsstruktur, wie einer Schaltung, wird die Metallpaste erhitzt. Hierbei verdampfen die organischen Hilfsstoffe weitestgehend und die Metallpartikel werden durch Weichlot miteinander verbunden, wobei sich intermetallische Phasen herausbilden. Da die organischen Hilfsstoffe bei der jeweiligen Arbeitstemperatur flüchtig sind, verbleiben keine störenden Rückstände. Die Haftung auf nichtmetallischen Substraten der Metallpasten wird durch das zuvor aufgebrachte Klebstoffmaterial gewährleistet, das eine für den jeweiligen Anwendungsbereich bzw. die angewandte Erhitzungstemperatur geeignete Zusammensetzung aufweist. Bei der Wärmebehandlung ist darauf zu achten, daß die Metallpulver keine Schmelze bilden, da sich sonst aufgrund der Oberflächenspannung der Schmelze diskrete Metallkügelchen bilden würden.

Die Wärmebehandlung zur Erzeugung elektrisch leitfähiger Verbindungsstrukturen bzw. zur Herstellung von Schaltungen und von bestückten Schaltungen kann in bei der Löttechnik bekannten Vorrichtungen durchgeführt werden. Beispielsweise eignet sich ein sogenannter Reflow-Ofen, wobei die Wärmebehandlung vorzugsweise unter Stickstoffgasatmosphäre durchgeführt wird. Hierbei ist es auch möglich, in die Gasatmosphäre Aktivatoren für die Metallpulver, wie vorzugsweise Ameisensäure, einzubringen. Andererseits können solche Aktivatoren, wie bereits oben erwähnt, auch in der Metallpaste enthalten sein.

Als Ergebnis des erfindungsgemäßen Verfahrens wird ein Schichtaufbau erhalten, der aus dem nunmehr vollständig gehärteten Klebstoffmaterial und einer darauf befindlichen, von organischen Beimengungen weitgehend freien Metallschicht besteht. Der besondere Vorteil eines derartigen Schichtaufbaus besteht in der Lötfähigkeit der metallischen Schicht. Dazu gegensätzlich sind die mittels bekannten leitfähigen Klebstoffen erzielten Verbindungsstrukturen aufgrund der innigen Vermischung von Metall und Polymermatrix in der derzeit vermarkteten und beschriebenen Form in der Regel nicht lötfähig.

Durch die Bildung intermetallischer Phasen gemäß der Erfindung ist die erneute Aufschmelztemperatur der Metalle erhöht, so daß eine hohe Wiederaufschmelztemperatur nachfolgende Lötprozesse ermöglicht. Gemäß der Erfindung ist die Erzeugung elektrisch leitfähiger Verbindungsstrukturen, wie Schaltungen, auf isolierenden Trägerwerkstoffen möglich, wobei als Substrate alle Arten von Trägern, beispielsweise Leiterplatten, flexible Leiterplatten, Aluminiumoxidkeramiken oder eloxierte Aluminiumplatinen ohne Schwierigkeiten eingesetzt werden können. Der Fachmann kann hierbei die geeigneten Klebstoffmaterialien bzw. Haftsysteme den jeweiligen Trägermaterialien anpassen. Durch geeignete Wahl der metallurgischen Komponenten lassen sich so flächige oder dreidimensionale, elektrisch leitfähige Strukturen erzeugen, welche durch nachfolgende, in der Produktion elektronischer Baugruppen übliche Bindungsschritte, wie etwa Löten, weiterverarbeitet werden können.

## Patentansprüche

1. Verfahren zur Erzeugung elektrisch leitfähiger Strukturen, umfassend die Schritte:
**(1)** Aufbringen eines Klebstoffmaterials auf einen Träger;
**(2)** Aufbringen einer mindestens zwei Metallpulver mit unterschiedlichen Schmelzpunkten in einer Gesamtmenge von mindestens 85 Gew.-% und eine geringe Menge organischer Hilfsstoffe, gewählt aus flüchtigen organischen Verbindungen, desoxidierenden Hilfsstoffen, die Metallpulver aktivierenden Substanzen und die Viskosität regelnden Additiven enthaltenden, elektrisch leitfähigen Metallpaste, wobei die Metallpaste mindestens ein Metallpulver eines Metalls guter elektrischer Leitfähigkeit aus der Gruppe Gold, Silber, Kupfer und deren Legierungen und mindestens ein Metallpulver eines Metalls mit niedrigerem Schmelzpunkt als demjenigen des Metalls guter elektrischer Leitfähigkeit aus der Gruppe Zinn, Indium und deren Legierungen enthält und wobei die Metallpulver in solchen Mengenanteilen gewählt sind, daß sie beim Erwärmen eine intermetallische Phase mit gegenüber den Ausgangsmetallen erhöhter Aufschmelztemperatur bilden und wobei die organischen Hilfsstoffe bei der zur Bildung der intermetallischen Phase angewandten Temperatur größtenteils verflüchtigbar sind, auf das so vorgesehene Klebstoffmaterial; und
**(3)** Erhitzen der so erhaltenen Anordnung bei einer Temperatur, bei der die Metallpulver eine intermetallische Phase mit einer gegenüber den Ausgangsmaterialien erhöhten Aufschmelztemperatur bilden.

2. Verfahren nach Anspruch 1, wobei das Klebstoffmaterial in Form eines Schaltungsmusters aufgebracht wird, um eine Schaltung zu erzeugen.

3. Verfahren nach Anspruch 2, wobei das mit dem Klebstoffmaterial und der Metallpaste versehene Schaltungsmuster vor dem Erhitzen mit elektrischen oder elektronischen Bauelementen bestückt wird, um eine bestückte Schaltung zu erzeugen.

4. Verfahren nach einem der Ansprüche 1 bis 3, wobei das aufgebrachte Klebstoffmaterial vor dem Aufbringen der Metallpaste einer Wärmebehandlung ausgesetzt wird, mit der Maßgabe, daß hierbei keine oder keine vollständige Härtung des Klebstoffmaterials erfolgt.

5. Verfahren nach mindestens einem der Ansprüche 1 bis 4, wobei die Aufbringung des Klebstoffmaterials und der Metallpaste mittels eines Dispensers, eines Sieb- oder anderen Druckverfahrens erfolgt.

6. Verfahren nach mindestens einem der Ansprüche 1 bis 5, wobei als Träger ein flächiger Schaltungsträger eingesetzt wird.

7. Verfahren nach Anspruch 1, bei dem das Klebstoffmaterial ein anorganisches oder organisches Material ist.

8. Verfahren nach Anspruch 7, bei dem das organische Material ein thermoplastisches Harz ist.

9. Verfahren nach Anspruch 7, bei dem das organische Material ein organisches härtbares Harz ist.

10. Verfahren nach Anspruch 9, bei dem das härtbare Harz ein Ein- oder Zweikomponenten-Klebstoff auf Epoxidharzbasis ist.

11. Verfahren nach Anspruch 1, bei dem das Metall mit niedrigerem Schmelzpunkt aus Legierungen von Zinn und/oder Indium mit Blei und/oder Antimon und/oder Zink, gewählt ist.

12. Verfahren nach Anspruch 1, bei dem die Metallpaste eine Mischung aus Kupferpulver und einem Pulver der Legierung 62Sn36Pb2Ag in einem Gewichtsverhältnis von etwa 4 : 1 bis etwa 1 : 1 enthält.

13. Verfahren nach Anspruch 1, bei dem die Metallpulver eine mittlere Teilchengröße von etwa 1 - 100 µm, vorzugsweise etwa 10 - 50 µm, weiter vorzugsweise etwa 20 - 30 µm, aufweisen.

## Claims

1. A method of producing electrically conductive structures, comprising the steps of:
**(1)** applying an adhesive material onto a substrate;
**(2)** applying an electrically conductive metal paste containing at least two metal powders having different melting points in a total amount of at least 85 % by weight and a small amount of organic auxiliary agents, selected from volatile organic compounds, desoxidizing auxiliary agents, metal powder activating substances and additives controlling the viscosity, wherein said metal paste contains at least one metal powder of a metal of good electrical conductivity selected from the group consisting of gold, silver, copper and their alloys, and at least one metal powder of a metal having a lower melting point than the metal of good electrical conductivity selected from the group consisting of tin, indium and their alloys, and wherein said metal powders are selected in such amounts that during heating they form an intermetallic phase at a melting temperature which is higher than that of the starting metals, and wherein said organic auxiliary agents are volatilizable for the most part at the temperature used for forming the intermetallic phase, onto the thus provided adhesive material; and
**(3)** heating the thus obtained arrangement at a temperature at which said metal powders form an intermetallic phase having a melting temperature higher than that of the starting materials.

2. The method according to claim 1, wherein said adhesive material is applied in the form of a circuit pattern for producing a circuit.

3. The method according to claim 2, wherein the circuit pattern provided with the adhesive material and the metal paste is equipped with electric or electronic components prior to heating for producing an equipped circuit.

4. The method according to anyone of claims 1 to 3, wherein the applied adhesive material prior to application of the metal paste undergoes thermal treatment subject to the condition that the adhesive material is not or not completely cured during this process.

5. The method according to anyone of claims 1 to 4, wherein the application of the adhesive material and the metal paste is made by means of a dispenser, a screening method, or any other printing method.

6. The method according to anyone of claims 1 to 5, wherein the substrate is a plane circuit base.

7. The method according to claim 1, wherein the adhesive material is an inorganic or organic material.

8. The method according to claim 7, wherein the organic material is a thermoplastic resin.

9. The method according to claim 7, wherein the organic material is an organic curable resin.

10. The method according to claim 9, wherein the curable resin is a one-component or two-component adhesive on the basis of an epoxy resin.

11. The method according to claim 1, wherein the metal having a lower melting point is selected from alloys of tin and/or indium with lead and/or antimony and/or zinc.

12. The method according to claim 1, wherein the metal paste contains a mixture of copper powder and a powder of the alloy 62Sn36Pb2Ag in a weight ratio of about 4 : 1 of about 1 : 1.

13. The method according to claim 1, wherein the metal powders having a mean particle size of from about 1 to 100 µm, preferably of from about 10 to 50 µm, more preferably of from about 20 to 30 µm.

## Revendications

1. Procédé de production de structures électriquement conductrices, comprenant les étapes consistant à :
(1) appliquer un matériau adhésif sur un support ;
(2) appliquer une pâte métallique électriquement conductrice contenant au moins deux poudres métalliques à point de fusion différent selon une quantité totale d'au moins 85 % en poids et une petite quantité d'agents auxiliaires organiques choisis parmi des composés organiques volatiles, des agents auxiliaires désoxydants, des substances activant les poudres métalliques et des additifs régulant la viscosité, la pâte métallique contenant au moins une poudre métallique d'un métal à bonne conductibilité électrique du groupe formé par l'or, l'argent, le cuivre et leurs alliages et au moins une poudre métallique d'un métal à point de fusion inférieur à celui du métal à bonne conductibilité électrique, du groupe formé par l'étain, l'indium et leur alliages, et les poudres métalliques étant choisies dans des proportions telles qu'en chauffant elles forment une phase intermétallique avec une température de fusion supérieure à celle des métaux de départ, et les agents auxiliaires organiques étant en grande partie volatilisables, à la température adoptée pour former la phase intermétallique, sur le matériau adhésif ainsi prévu ; et
(3) chauffer l'agencement ainsi obtenu à une température à laquelle les poudres métalliques forment une phase intermétallique possédant une température de fusion supérieure à celle des matériaux de départ.

2. Procédé selon la revendication 1, dans lequel le matériau adhésif est appliqué sous la forme d'un motif de circuit pour obtenir un circuit.

3. Procédé selon la revendication 2, dans lequel le motif de circuit revêtu du matériau adhésif et de la pâte métallique est équipé, avant d'être chauffé, de composants électriques ou électroniques pour produire un circuit équipé.

4. Procédé selon l'une des revendications 1 à 3, dans lequel, préalablement à l'application de la pâte métallique, le matériau adhésif appliqué est soumis à un traitement thermique en veillant à ce que le matériau adhésif ne durcisse pas ou pas complètement.

5. Procédé selon au moins une des revendications 1 à 4, dans lequel l'application du matériau adhésif et de la pâte métallique s'effectue au moyen d'un applicateur, d'un procédé sérigraphique ou d'un autre procédé d'impression.

6. Procédé selon au moins une des revendications 1 à 5, dans lequel le support mis en oeuvre est un support de circuit plat.

7. Procédé selon la revendication 1, dans lequel le matériau adhésif est un matériau inorganique ou organique.

8. Procédé selon la revendication 7, dans lequel le matériau organique est une résine thermoplastique.

9. Procédé selon la revendication 7, dans lequel le matériau organique est une résine organique durcissable.

10. Procédé selon la revendication 9, dans lequel la résine durcissable est un adhésif à un ou deux composants à base de résine époxy.

11. Procédé selon la revendication 1, dans lequel le métal à point de fusion inférieur est choisi parmi des alliages d'étain et/ou d'indium avec du plomb et/ou de l'antimoine et/ou du zinc.

12. Procédé selon la revendication 1, dans lequel la pâte métallique contient un mélange constitué de poudre de cuivre et d'une poudre de l'alliage 62Sn36Pb2Ag selon un rapport pondéral d'environ 4 : 1 à environ 1 : 1.

13. Procédé selon la revendication 1, dans lequel les poudres métalliques présentent une granulométrie moyenne d'environ 1 à 100 µm, de préférence d'environ 10 à 50 µm, selon une préférence encore plus grande d'environ 20 à 30 µm.
